# EUROPÄISCHE PATENTSCHRIFT

(11) **EP 0 455 015 B1**
(45) Veröffentlichungstag und Bekanntmachung des Hinweises auf die Patenterteilung: **26.02.1997**
(21) Anmeldenummer: 91105722.2
(22) Anmeldetag: 11.04.1991
(51) Int. Cl.: H01S 3/085, H01L 33/00

(54) **Halbleiter-Laser**
Semiconductor laser
Laser à semi-conducteur

(30) Priorität: 02.05.1990 DE 4014032
(43) Veröffentlichungstag der Anmeldung: 06.11.1991
(73) Patentinhaber: Alcatel SEL Aktiengesellschaft, D-70435 Stuttgart (DE); ALCATEL N.V., NL-1077 XX Amsterdam (NL)
(72) Erfinder: Schilling, Michael, W-7000 Stuttgart 31 (DE)
(74) Vertreter: Pohl, Herbert, Dipl.-Ing

(56) Entgegenhaltungen:
- EP-A- 0 321 328
- ELECTRONICS LETTERS, Bd. 19, Nr. 14, 7. Juli 1983, Stevenage, Herts, GB, Seiten 507-509; H. ASAHI et al.: 'Hybrid LPE/MBE-grown InGaAsP/InP DFB lasers'
- JAPANESE JOURNAL OF APPLIED PHYSICS, Bd. 22, Nr. 5, Mai 1983, Tokyo, JP, Seiten L291-L293; H. NAGAI et al.: 'Prevention of surface corrugation thermal deformation for InGaAsP/InP DFB lasers'
- PATENT ABSTRACTS OF JAPAN, vol. 14, no. 550 (E-1009) 6. Dezember 1990 ; & JP-A-2 235 386

## Beschreibung

Die Erfindung betrifft einen Halbleiterlaser gemäß dem Oberbegriff des Patentanspruchs 1. Es sind Halbleiterlaser, insbesondere DFB-Laser (Distributed-Feedback-Laser), bekannt, die ein vorzugsweise naßchemisch geätztes, flaches Gitter erster Ordnung aufweisen. Auf das Gitter wird im MOVPE-Verfahren (Metal organic vapor phase epitaxy-Verfahren) eine Schichtenfolge aufgebracht, wobei unmittelbar auf das Gitter eine Wellenleiter-Schicht aufgewachsen wird. Das Aufbringen der Schichten im MOVPE-Verfahren führt dazu, daß sehr dünne aktive Schichten auf die Wellenleiter-Schicht aufgebracht werden können, was insbesondere bei 1,55 µm-Lasern zu einer hohen Quantenausbeute und einer hohen Ausgangsleistung führt. Die Aufbringung der Wellenleiter-Schicht auf das Gitter mittels des MOVPE-Verfahrens ist allerdings nur dann ohne Beeinträchtigung des Gitters möglich, wenn die Tiefe des Gitters nicht besonders ausgeprägt ist. Dies führt jedoch dazu, daß der Kopplungskoeffizient des Halbleiterlasers nicht optimal ist.

Es ist bekannt, daß der Kopplungskoeffizient durch tiefe Gitter zweiter Ordnung verbessert werden kann, wobei vorzugsweise noch die Form des Gitters besonders ausgelegt wird. Das heißt, die Flanken der einzelnen Erhebungen des Gitters werden unter einem speziellen Winkel geneigt. Überdies werden das Tastverhältnis und die Tiefe des Gitters so gewählt, daß sich insgesamt ein optimaler Kopplungskoeffizient ergibt. Dadurch wird insbesondere die Rückwirkungsempfindlichkeit des Halbleiterlasers verbessert.

Es hat sich allerdings herausgestellt, daß die Wellenleiter-Schicht auf derartige Gitter nicht mit dem MOVPE-Verfahren aufgebracht werden kann. Die bei diesem Verfahren erforderlichen Temperaturen führen zu einer Beeinträchtigung des Gitters, das heißt, die einzelnen Stege des Gitters werden abgerundet, so daß die für den optimalen Kopplungskoeffizienten gewählten Vorgaben für den Flankenwinkel und die Gittertiefe nicht mehr gegeben sind, wenn die Wellenleiter-Schicht aufgebracht ist.

Es ist überdies nicht möglich, im LPE-Verfahren sehr dünne aktive Schichten auf die Wellenleiter-Schicht aufzubringen, wodurch die Quantenausbeute und die optische Ausgangsleistung eines im LPE-Verfahren hergestellten Lasers unzureichend sind. Erschwerend kommt beim LPE-Verfahren hinzu, daß zusätzlich eine Rücklösestopschicht auf die aktive Schicht aufgebracht werden muß, bevor weitere Schichten aufgewachsen werden. Dadurch wird die effektive aktive Schichtdicke erhöht.

Aufgabe der Erfindung ist, einen Halbleiterlaser zu schaffen, bei dem die Rückwirkungsempfindlichkeit reduziert ist, wobei eine hohe Quantenausbeute erreicht werden soll.

Diese Aufgabe wird bei einem Halbleiterlaser der eingangs genannten Art mit Hilfe der in Anspruch 1 genannten Merkmale gelöst.

Dadurch, daß die Wellenleiter-Schicht auf das Gitter im LPE-Verfahren aufgebracht wird, bleiben dessen Gitterstrukturen erhalten, wobei gleichzeitig eine optimale Planisierung erzielt wird. Das heißt, die zwischen den Rippen des Gitters bestehenden Vertiefungen werden ausgefüllt, die über den Rippen liegenden Schichtdicken der Wellenleiter-Schicht sind sehr gering. Dadurch, daß die über der Wellenleiter-Schicht liegenden Schichten mittels eines Gasphasen- oder eines Molekularstrahl-Verfahrens aufgebracht sind, lassen sich, im Gegensatz zum LPE-Verfahren, sehr dünne Schichten, insbesondere eine sehr dünne aktive Schicht aufbringen. Dadurch lassen sich die gewünschten Eigenschaften des Lasers erreichen: Bei einer sehr geringen Rückwirkungsempfindlichkeit ergibt sich eine hohe Quantenausbeute und eine hohe Ausgangsleistung. Dabei ist der Schwellenstrom sehr niedrig. Schließlich ist ein stabiler Einmodenbetrieb gewährleistet.

Vorzugsweise ist eine Optimierung des Kopplungskoeffizienten vorgesehen, indem der Flankenwinkel, das Tastverhältnis sowie die Tiefe des Gitters auf bekannte Weise abgestimmt werden. Dadurch, daß dieses relativ tiefe Gitter im LPE-Verfahren mit einer Wellenleiter-Schicht versehen ist, bleibt die Gitterstruktur optimal erhalten. Da die nachfolgenden Schichten im Gasphasenbeziehungsweise Molekularstrahl-Epitaxieverfahren aufgebracht werden, lassen sich die gewünschten dünnen Schichtdicken erzielen, was zu den genannten Vorteilen führt.

Weitere Ausführungsformen des Halbleiterlasers ergeben sich aus den Unteransprüchen.

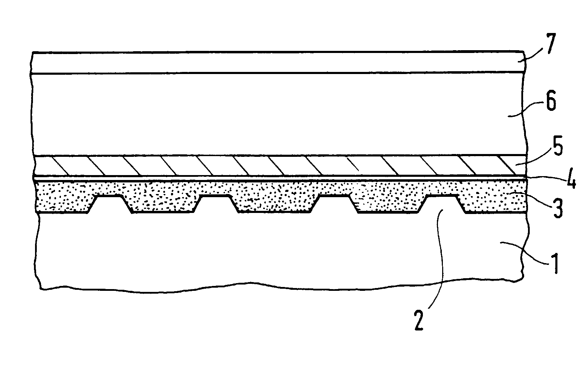

Die Erfindung wird im folgenden anhand der Zeichnung näher erläutert, die eine Prinzipskizze eines Lasers im Schnitt wiedergibt. Der Schnitt verläuft hier parallel zur Ausbreitungsrichtung des Lichts; er zeigt eigentlich einen Querschnitt durch einen Wafer, aus dem Laser der im folgenden beschriebenen Art hergestellt werden sollen.

Aus der Schnittdarstellung ist ersichtlich, daß auf ein InP-Substrat 1 ein DFB-Gitter 2 aufgebracht ist. Dabei wird vorzugsweise ein Trockenätzverfahren verwendet. Es kann etwa durch Ionenbeschuß hergestellt werden. Das Gitter ist vorzugsweise so ausgelegt, daß sich ein optimaler Kopplungskoeffizient ergibt, das heißt, das Tastverhältnis des Gitters, dessen Tiefe sowie der Neigungswinkel der Flanken der Erhebungen des Gitters sind speziell gewählt.

Besonders vorteilhaft ist es, daß die Wellenleiter-Schicht 3 im LPE-Verfahren aufgebracht wird, wobei die Gitterstruktur unbeeinträchtigt erhalten bleibt. Insbesondere werden Deformationen des Gitters vermieden. Gleichzeitig ergibt sich eine optimale Planisierung, das heißt, infolge des ausgeprägten lateralen Schichtenwachstums beim LPE-Verfahren ergibt sich eine vollständige Ausfüllung der zwischen den Rippen verlaufenden Vertiefungen des Gitters, so daß die ursprünglich geriffelte Wafer-Oberfläche vollständig plan wird.

Die auf der Wellenleiter-Schicht 3 angeordneten Schichten werden nicht im LPE-Verfahren aufgebracht, sondern mit Hilfe eines Gasphasen- oder Molekularstrahl-Epitaxieverfahrens. Als Gasphasenverfahren hat sich das MOVPE-Verfahren und als Molekularstrahl-Epitaxieverfahren das MOMBE-, GSMBE- oder das CBE-Verfahren als geeignet herausgestellt.

Die beiden genannten Verfahrensarten zeichnen sich dadurch aus, daß besonders dünne Schichten aufbringbar sind.

Zunächst kann auf die Wellenleiter-Schicht 3 eine sehr dünne InP-Pufferschicht 4 aufgebracht werden, die beispielsweise eine Stärke von weniger als 0,1 µm haben kann. Sie dient sowohl zur Qualitätsverbesserung des Halbleiterlasers als auch als Ätzstop-Schicht bei weitergehender Strukturierung des Halbleiterlasers zum Beispiel für die Integration mit Wellenleiterbauelementen.

Über die Pufferschicht wird eine aktive Schicht 5 aufgebracht, die quaternär sein kann, aber auch aus einer MQW-Schichtfolge (Muli-Quantum-Well-Schichtfolge) bestehen kann. Bei letzterer werden zahlreiche ganz besonders dünne Schichten aus verschiedenen Materialien übereinander aufgebracht, deren Gesamtdicke etwa der Dicke der aktiven Schicht 5 entspricht. Vorzugsweise werden abwechselnd InP-Schichten und InGaAs-Schichten aufgebracht.

Mit Hilfe derartiger Schichten läßt sich die Quantenausbeute noch weiter steigern.

Die aktive Schicht wird mittels der genannten Verfahren mit einer Mantelschicht 6, vorzugsweise mit einer InP-Schicht überzogen, worauf dann schließlich eine hoch dotierte Kontaktschicht 7 aus ternärem oder quaternärem Material aufgebracht wird.

Die weitere Verarbeitung des Wafers zu Lasern erfolgt nach den üblichen Herstellungsverfahren.

Durch die Kombination der hier genannten Beschichtungsverfahren lassen sich insbesondere die Eigenschaften von 1,55 µm DFB-Hochgeschwindigkeitslasern verbessern, ohne daß die Herstellung wesentlich verteuert wurde. Insgesamt wurde also ein einfaches Herstellungsverfahren für Laser, insbesondere für einen DFB-Laser mit hybrid-epitaktisch hergestelltem Schichtaufbau gefunden, der stabil im Einmodembetrieb arbeitet und mit dem eine reduzierte Rückwirkungsempfindlichkeit bei sehr guter Quantenausbeute erreichbar ist. Dabei ist der Schwellenstrom des Lasers sehr gering.

Durch die gezielte Kombination der Epitaxieverfahren lassen sich die Vorteile dieser Verfahren optimal kombinieren. Insbesondere wird erreicht, daß die der Wellenführung dienenden Schichten die Wellenleiter-Schicht und die aktive Schicht mit Hilfe von verschiedenen Epitaxieverfahren hergestellt werden, wobei die Wellenleiter-Schicht im LPE-Verfahren und die aktive Schicht im Gasphasen- beziehungsweise Molekularstrahl-Epitaxieverfahren hergestellt wird. Dabei wird die Struktur des an die Wellenleiter-Schicht angrenzenden Gitters nicht beeinträchtigt, so daß sich ein optimaler Kopplungskoeffizient einstellen läßt.

## Patentansprüche

1. Halbleiterlaser mit einem auf einem Substrat (1) aufgebrachten Gitter (2), einer auf diesem Gitter aufliegenden, mittels des LPE-Verfahrens aufgebrachten Wellenleiterschicht (3) und einer auf der Wellenleiterschicht aufliegenden,mittels eines Gasphasen- oder eines Molekularstrahl- Epitaxieverfahrens aufgebrachten Schichtenfolge (4, 5, 6, 7), die nacheinander eine aktive Schicht (5), eine Mantelschicht (6) und eine Kontaktschicht (7) enthält, wobei das Gitter (2) in bezug auf die Wellenlänge des vom Halbleiterlaser emittierten Lichtes als DFB-Gitter zweiter Ordnung ausgebildet ist, dessen Tiefe, Flankenwinkel und Tastverhältnis auf optimale Kopplung mit dem emittierten Licht abgestimmt sind, und wobei die Wellenleiterschicht (3) auf ihrer dem Gitter abgewandten Oberfläche plan ist.

2. Halbleiterlaser nach Anspruch 1, dadurch gekennzeichnet, daß zwischen der Wellenleiterschicht (3) und der aktiven Schicht (5) eine Pufferschicht (4) vorgesehen ist.

3. Halbleiterlaser nach Anspruch 1 oder 2, dadurch gekennzeichnet, daß als Wellenleiterschicht (3) eine quaternäre Schicht, als aktive Schicht (5) eine quaternäre Schicht oder eine MQW-Schichtenfolge und als Kontaktschicht (7) eine ternäre oder quaternäre Schicht vorgesehen sind.

4. Halbleiterlaser nach Anspruch 1-3, dadurch gekennzeichnet, daß die Schichten der auf der Wellenleiterschicht aufliegenden Schichtenfolge mittels des MOVPE-Verfahrens aufgebracht sind.

5. Halbleiterlaser nach Anspruch 1-3, dadurch gekennzeichnet, daß die Schichten der auf der Wellenleiterschicht aufliegenden Schichtenfolge mittels des MOMBE-, GSMBE- oder des CBE-Verfahrens aufgebracht sind.

## Claims

1. Semiconductor laser having a grating (2) deposited on a substrate (1), a waveguide layer (3) overlying said grating and deposited by means of the LPE process and a layer sequence (4, 5, 6, 7) which overlies the waveguide layer and has been deposited by means of a gas-phase or a molecular-beam epitaxial process and which comprises, consecutively, an active layer (5), a cladding layer (6) and a contact layer (7), wherein the grating (2) is formed, in relation to the wavelength of the light emitted by the semiconductor laser, as a second-order DFB grating whose depth, slope angle and top-to-bottom ratio have been adjusted for optimum coupling with the emitted light, and wherein the waveguide layer (3) is flat on its surface remote from the grating.

2. Semiconductor laser according to Claim 1, characterized in that a buffer layer (4) is provided between the waveguide layer (3) and the active layer (5).

3. Semiconductor laser according to Claim 1 or 2, characterized in that a quaternary layer is provided as waveguide layer (3), a quaternary layer or an MQW layer sequence is provided as active layer (5) and a ternary or quaternary layer is provided as contact layer (7).

4. Semiconductor laser according to Claim 1 - 3, characterized in that the layers of the layer sequence overlying the waveguide layer have been deposited by means of the MOVPE process.

5. Semiconductor laser according to Claim 1 - 3, characterized in that the layers of the layer sequence overlying the waveguide layer have been deposited by means of the MOMBE, GSMBE or the CBE process.

## Revendications

1. Laser à semi-conducteur possédant une grille de diffraction (2) appliquée sur un substrat (1), une couche guide d'ondes (3) appliquée sur cette grille selon la méthode LPE, et une suite de couches (4, 5, 6, 7) appliquée sur la couche guide d'ondes selon la méthode épitaxie en phase gazeuse ou à rayon moléculaire. Cette suite de couches étant formée d'une couche active (5), d'une couche d'isolation (6) et d'une couche métallique (7). Laser dans lequel la grille de diffraction (2) est fabriquée comme une grille DFB de second ordre en rapport avec la longueur d'onde de la lumière émise par le laser à semi-conducteur. Grille de diffraction dont la profondeur, l'angle des côtés et les intervalles sont définis pour obtenir un couplage optimal avec la lumière émise. Laser dans lequel la surface de la couche guide d'ondes (3) opposée à la grille est plane.

2. Laser à semi-conducteur suivant la revendication 1, caractérisé par le fait qu'entre la couche guide d'ondes (3) et la couche active (5) se trouve une couche tampon (4).

3. Laser à semi-conducteur suivant les revendications 1 ou 2, caractérisé par le fait que l'on utilise une couche quaternaire pour la couche guide d'ondes (3), une couche quaternaire ou une suite de couches MQW pour la couche active (5) et une couche quaternaire ou ternaire pour la couche métallique (7).

4. Laser à semi-conducteur suivant les revendications 1 à 3, caractérisé par le fait que les couches la suite de couches sont appliquées sur la couche guide d'ondes grâce à la méthode MOVPE.

5. Laser à semi-conducteur suivant les revendications 1 à 3, caractérisé par le fait que les différentes couches composant la suite de couches sont appliquées sur la couche guide d'ondes grâce aux méthodes MOMBE, GSMBE, ou CBE.
